# EUROPEAN PATENT SPECIFICATION

(11) **EP 3 910 633 B1**
(45) Date of publication and mention of the grant of the patent: **18.11.2026**
(21) Application number: 19909127.3
(22) Date of filing: 22.11.2019
(51) Int. Cl.: G11C 29/02, G11C 7/10, G11C 5/14, G11C 16/30

(54) **OUTPUT CIRCUIT AND CHIP**
AUSGANGSSCHALTUNG UND CHIP
CIRCUIT DE SORTIE ET PUCE

(30) Priority: 07.01.2019 CN 201910012322
(43) Date of publication of application: 17.11.2021
(73) Proprietor: Changxin Memory Technologies, Inc., Hefei City, Anhui 230000 (CN)
(72) Inventor: TIAN, Kai, Hefei City, Anhui Province (CN)
(74) Representative: Lavoix
(86) International application number: PCT/CN2019/120207
(87) International publication number: WO 2020/143339

(56) References cited:
- CN-A- 102 487 240
- CN-A- 107 947 784
- CN-A- 108 305 647
- CN-U- 209 045 167
- US-A1- 2015 063 041
- US-A1- 2017 092 348
- US-B2- 7 161 865
- US-B2- 7 714 618
- CHAE M ET AL: "Multi-standard low-power DDR I/O circuit design in 7nm CMOS process", 2017 IEEE INTERNATIONAL SYMPOSIUM ON CIRCUITS AND SYSTEMS (ISCAS), IEEE, 28 May 2017 (2017-05-28), pages 1 - 4, XP033156006, DOI: 10.1109/ISCAS.2017.8050331

## Description

### CROSS-REFERENCE TO RELATED APPLICATIONS

This application claims priority to Chinese Patent Application No. 201910012322.0, filed with the China National Intellectual Property Administration on January 7, 2019 and entitled "OUTPUT CIRCUIT AND CHIP".

### TECHNICAL FIELD

The present invention relates to semiconductor memories, and in particular to an output circuit and a chip.

### BACKGROUND

In both LPDDR4 (Low Power Double Data Rate SDRAM 4) and LPDDR4X applications, a high-speed interface standard of LVSTL (Low Voltage Swing Terminated Logic) is used, and different output pull-down driver capabilities and output high levels can be configured by a memory controller. However, because voltages of data output ports of the two are different, LPDDR4 and LPDDR4X cannot be applied to the same chip. This brings trouble to the application and design of the chip.

Background may be found in US2015/063041 and CHEN M ET AL: "Multi-standard low-power DDR I/O circuit design in 7nm CMOS process".

US 7,161,865 B2 discloses a semiconductor device with a plurality of output circuits one of which is selected according to a supplied power.

### SUMMARY

The present invention provides an output circuit and a chip, as defined in the appended claims.

### BRIEF DESCRIPTION OF THE DRAWINGS

In the accompanying drawings, reference numerals that are identical throughout the plurality of accompanying drawings represent identical or similar components or elements, unless otherwise specified. These accompanying drawings are not necessarily drawn in scale. It should be understood that the accompanying drawings describe only some embodiments of the present invention, and should not be considered as limiting the scope of the present invention.
FIG. 1 is a schematic connection diagram of an output circuit according to an embodiment of the present invention.
FIG. 2 is a schematic structural diagram of a fourth-stage circuit according to an embodiment of the present invention.
FIG. 3 is a schematic structural diagram of a pull-up branch in a pull-up circuit according to an embodiment of the present invention.
FIG. 4 is a schematic structural diagram of a pull-down branch in a pull-down circuit according to an embodiment of the present invention.
FIG. 5 is a schematic structural diagram of a first-stage circuit according to an embodiment of the present invention.
FIG. 6 is a schematic structural diagram of a pull-down control module in a second-stage circuit according to an embodiment of the present invention.
FIG. 7 is a schematic structural diagram of a pull-up control module in a second-stage circuit according to an embodiment of the present invention.
FIG. 8 is a schematic structural diagram of a pull-up switch module in a second-stage circuit according to an embodiment of the present invention.
FIG. 9 is a schematic structural diagram of a third-stage circuit according to an embodiment of the present invention.
FIG. 10 is a schematic structural diagram of a pull-up control submodule (pull-down control submodule) in a third-stage circuit according to an embodiment of the present invention.

### Reference numerals:

100 first-stage circuit;
110 first pull-up control module;
120 first pull-down control module;
130 delay unit;
200 second-stage circuit;
210 second pull-down control module;
210a pull-down path unit;
211 first NAND gate;
212 second NAND gate;
213 third NAND gate;
220 second pull-up control module;
220a pull-up path unit;
221 fourth NAND gate;
222 first phase inverter;
230 pull-up switch control module;
230a pull-up switch unit;
231 fifth NAND gate;
232 second phase inverter;
300 third-stage circuit;
310 third pull-up control module;
320 third pull-down control module;
330 pull-up control submodule;
340 pull-down control submodule;
331 sixth NAND gate;
332 third phase inverter;
400 fourth-stage circuit;
410 pull-up circuit;
411 pull-up branch;
411a first thin-gate low-threshold NMOS transistor;
411b first low-voltage calibration MOS transistor;
411c third thin-gate low-threshold NMOS transistor;
411d first fixed-value resistor;
411e second fixed-value resistor;
420 pull-down circuit;
421 pull-down branch;
421a second thin-gate low-threshold NMOS transistor;
421b second low-voltage calibration MOS transistor;
421c fourth thin-gate low-threshold NMOS transistor;
421d third fixed-value resistor;
421e fourth fixed-value resistor;
430 pull-up switch module;
431 thick-gate high-threshold NMOS transistor.

### DETAILED DESCRIPTION

In the following, only some example embodiments are briefly described. As will be appreciated by those skilled in the art, the described embodiments may be modified in various ways within the scope of the appended claims. Only embodiments or examples comprising all features of claim 1 fall under the scope of protection of the present invention, while the remaining ones correspond to illustrative examples which are useful for the understanding of the relevant technical context. Therefore, the accompanying drawings and descriptions are considered to be essentially exemplary and not limiting.

A first aspect of the embodiments provides an output circuit.

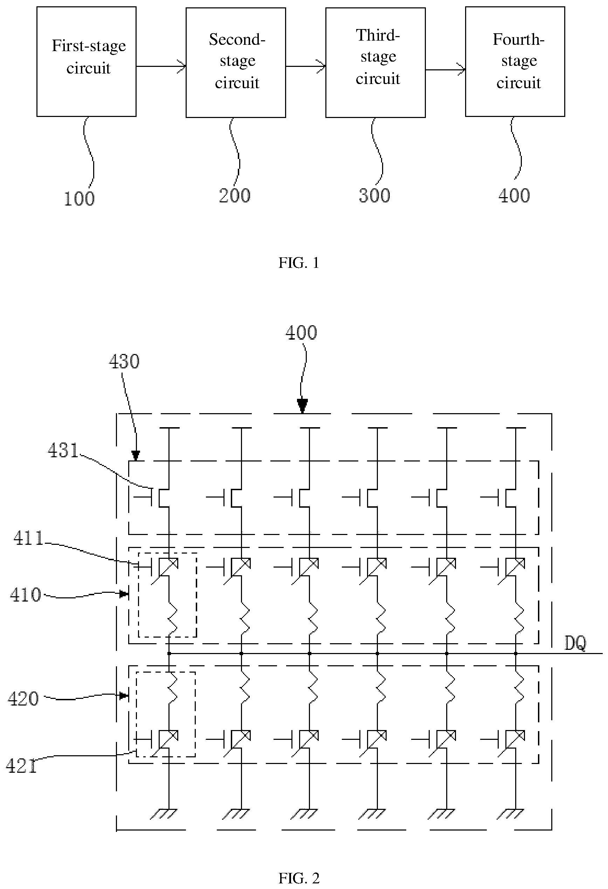

Referring to FIG. 1, the output circuit includes a first-stage circuit 100, a second-stage circuit 200, a third-stage circuit 300, and a fourth-stage circuit 400.

The first-stage circuit 100 is configured to: read serial data in a memory and divide the serial data into a plurality of voltage signals each at a specified rate level.

The second-stage circuit 200 is connected to the first-stage circuit 100, and the second-stage circuit 200 is configured to: receive the plurality of voltage signals output by the first-stage circuit 100, generate a plurality of voltage signals, and allocate a transmission path to each of the generated voltage signals.

The third-stage circuit 300 is connected to the second-stage circuit 200, and the third-stage circuit 300 is configured to: receive the plurality of voltage signals output by the second-stage circuit 200, and allocate a transmission path to each of the received voltage signals according to a ZQ calibration signal. The third-stage circuit 300 is further configured to adjust a voltage conversion rate of a data signal to control a voltage conversion rate of the fourth-stage circuit 400.

The fourth-stage circuit 400 is connected to the third-stage circuit 300. As shown in FIG. 2, the fourth-stage circuit 400 includes a pull-up circuit 410 and a pull-down circuit 420. Both the pull-up circuit 410 and the pull-down circuit 420 include a plurality of parallel thin-gate low-threshold NMOS transistors. The fourth-stage circuit 400 is configured to receive the plurality of voltage signals output by the third-stage circuit 300, and generate output voltage signals of the output circuit according to the received voltage signals. The thin-gate low-threshold NMOS transistors in the pull-up circuit 410 and the pull-down circuit 420 are configured to eliminate the limit on a minimum operating power supply voltage caused by a MOS transistor enable threshold voltage.

In this embodiment, the thin-gate low-threshold NMOS transistors in the pull-up circuit 410 and the pull-down circuit 420 increase a response speed of the output circuit and obtain a larger current per unit area, the limit on the minimum operating power supply voltage caused by the enable threshold voltage is eliminated, and two or more different high-speed data transmission standards become compatible. Therefore the chip may work in two environments with different output levels.

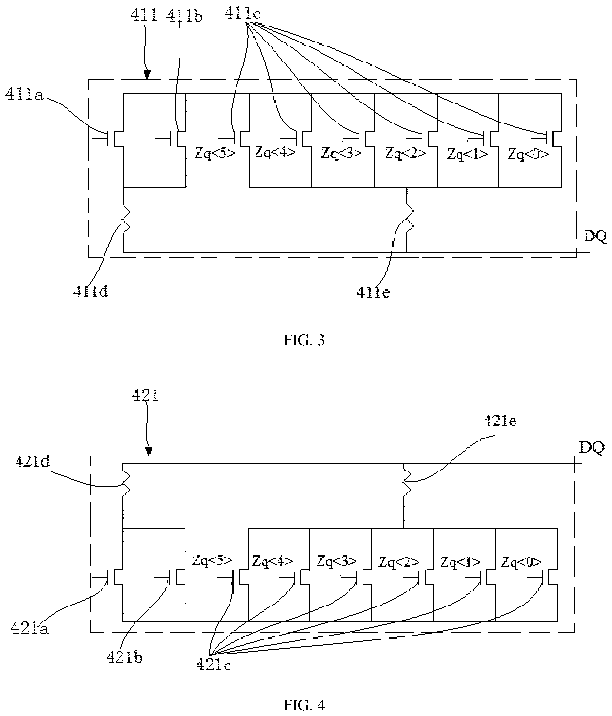

In an embodiment, referring to FIG. 2 and FIG. 3, the pull-up circuit 410 includes a plurality of parallel pull-up branches 411, and each of the pull-up branches 411 includes a first thin-gate low-threshold NMOS transistor 411a. A drain of the first thin-gate low-threshold NMOS transistor 411a is connected to a power supply voltage, and a gate of the first thin-gate low-threshold NMOS transistor 411a is configured to receive a pull-up voltage signal output by the third-stage circuit 300. Sources of the first thin-gate low-threshold NMOS transistors 411a of the pull-up branches 411 are connected as a data output terminal.

In an embodiment, referring to FIG. 2 and FIG. 4, the pull-down circuit 420 includes a plurality of parallel pull-down branches 421, and each of the pull-down branches 421 includes a second thin-gate low-threshold NMOS transistor 421a. A source of the second thin-gate low-threshold NMOS transistor 421a is grounded, a drain of the second thin-gate low-threshold NMOS transistor 421a is connected to the source of the first thin-gate low-threshold NMOS transistor 411a, and a gate of the second thin-gate low-threshold NMOS transistor 421a is configured to receive a pull-down voltage signal output by the third-stage circuit 300.

In this embodiment, the thin-gate low-threshold NMOS transistor is used in the pull-up circuit 410 and the pull-down circuit 420, to eliminate the limit on the minimum operating power supply voltage caused by an enable threshold voltage of an output transistor in a CMOS structure, so that the fourth-stage circuit 400 meets a plurality of output voltage standards.

In an embodiment, the third-stage circuit 300 is further configured to output a plurality of pull-up ZQ calibration signals during ZQ calibration.

Referring to FIG. 3, each of the pull-up branches 411 includes a plurality of third thin-gate low-threshold NMOS transistors 411c, and the third thin-gate low-threshold NMOS transistor 411c in each pull-up branch 411 is connected in parallel to the first thin-gate low-threshold NMOS transistor 411a. A gate of the third thin-gate low-threshold NMOS transistor 411c is configured to receive the pull-up ZQ calibration signal, and the third thin-gate low-threshold NMOS transistor 411c is configured to adjust an equivalent resistance of the pull-up branch 411 to RZQ according to the pull-up ZQ calibration signal.

In an embodiment, the third-stage circuit 300 is further configured to output a plurality of pull-down ZQ calibration signals during ZQ calibration.

Referring to FIG. 4, each of the pull-down branches 421 includes a plurality of fourth thin-gate low-threshold NMOS transistors 421c, and the fourth thin-gate low-threshold NMOS transistor 421c in each pull-down branch 421 is connected in parallel to the second thin-gate low-threshold NMOS transistor 421a. A gate of the fourth thin-gate low-threshold NMOS transistor 421c is configured to receive the pull-down ZQ calibration signal, and the fourth thin-gate low-threshold NMOS transistor 421c is configured to adjust an equivalent resistance of the pull-down branch to RZQ according to the pull-down ZQ calibration signal.

Further, the plurality of third thin-gate low-threshold NMOS transistors 411c and the plurality of fourth thin-gate low-threshold NMOS transistors 421c each have successively increasing equivalent width-to-length ratios.

Based on the foregoing embodiment, referring to FIG. 3, in a specific embodiment, the third-stage circuit 300 is further configured to output six pull-up ZQ calibration signals Zq<0>, Zq<1>, Zq<2>, Zq<3>, Zq<4>, and Zq<5> during ZQ calibration.

Each pull-up branch 411 includes six third thin-gate low-threshold NMOS transistors 411c. The gate of one third thin-gate low-threshold NMOS transistor 411c is connected to one calibration signal in the pull-up ZQ calibration signals Zq<5:0>.

Referring to FIG. 4, the third-stage circuit 300 is further configured to output six pull-down ZQ calibration signals Zq<0>, Zq<1>, Zq<2>, Zq<3>, Zq<4>, and Zq<5> during ZQ calibration.

Each pull-down branch 421 includes six fourth thin-gate low-threshold NMOS transistors 421c. The gate of one fourth thin-gate low-threshold NMOS transistor 421c is connected to one calibration signal in the pull-down ZQ calibration signals Zq<5:0>.

In a specific embodiment, the equivalent width-to-length ratio of each of the six third thin-gate low-threshold NMOS transistors 411c and the six fourth thin-gate low-threshold NMOS transistors 421c is 1:2:4:8:16:32.

According to the JEDEC memory standards, pull-down driver strength (that is, an equivalent pull-down output resistance) of the output circuit has six options: RZQ/1 to RZQ/6. Because six parallel branches of the same structure are used for a pull-down output stage, an equivalent resistance of each pull-down branch is adjusted to RZQ, and a preferred value of RZQ includes 240Ω. According to the JEDEC memory standards, the pull-up circuit corresponds to six ODT resistance values. To control VOH=VDDQ/3, six parallel branches of the same structure are also used for a pull-up output stage, and an equivalent resistance of each pull-up branch is also adjusted to RZQ.

In this embodiment, six thin-gate low-threshold NMOS transistors are connected in parallel to each pull-up branch 411 and each pull-down branch 421 for ZQ calibration, and the equivalent resistance of each of the pull-up branch 411 and the pull-down branch 421 is effectively adjusted to the reference resistance.

In an embodiment, referring to FIG. 1, the pull-up circuit 410 further includes a pull-up switch module 430.

The pull-up switch module 430 includes a thick-gate high-threshold NMOS transistor 431. A drain of the thick-gate high-threshold NMOS transistor 431 is connected to the power supply voltage, a source of the thick-gate high-threshold NMOS transistor 431 is connected to the drain of the first thin-gate low-threshold NMOS transistor 411a, and a gate of the thick-gate high-threshold NMOS transistor 431 is configured to receive a high-voltage threshold signal output by the third-stage circuit 300. When the pull-up circuit410 uses the first thin-gate low-threshold NMOS transistor 411a, the thick-gate high-threshold NMOS transistor 431 is connected between the power supply voltage and the first thin-gate low-threshold NMOS transistor 41 1a, thereby effectively reducing a static leakage current. In addition, to reduce the impact of a relatively large equivalent resistance of the thick-gate high-threshold NMOS transistor 431 on the pull-up switch module 430, during ZQ calibration, the pull-up switch module 430 is included together for calibration. In addition, the accuracy and linearity of the on-resistance are not affected when all the branches are connected in parallel.

In an embodiment, referring to FIG. 3, each of the pull-up branches 410 further includes at least one first low-voltage calibration MOS transistor 411b, the first low-voltage calibration MOS transistor 411b is connected in parallel to the first thin-gate low-threshold NMOS transistor 411a, the gate of the first low-voltage calibration MOS transistor 411b is connected to the third-stage circuit, and the first low-voltage calibration MOS transistor 411b is configured to be turned on at the time of receiving a low-voltage signal.

In an embodiment, referring to FIG. 4, each of the pull-down branches 420 further includes at least one second low-voltage calibration MOS transistor 421b, the second low-voltage calibration MOS transistor 421b is connected in parallel to the second thin-gate low-threshold NMOS transistor 421a, the gate of the second low-voltage calibration MOS transistor 421b is connected to the third-stage circuit 300, and the second low-voltage calibration MOS transistor 421b is configured to be turned on at the time of receiving a low-voltage signal.

The low-voltage signals received by the first low-voltage calibration MOS transistor 411b and the second low-voltage calibration MOS transistor 421b and the pull-up/pull-down voltage signal are homologous signals.

In a specific embodiment, both the first low-voltage calibration MOS transistor 411b and the second low-voltage calibration MOS transistor 421b are thin-gate low-threshold NMOS transistors, and the thin-gate low-threshold NMOS transistors are corrected in parallel in the pull-up/pull-down circuit for correction, so as to effectively prevent the case below: the equivalent resistance in the pull-up/pull-down circuit has a relatively large change and is completely dependent on ZQ calibration, and a calibration range is narrowed.

In an embodiment, referring to FIG. 3, a first fixed-value resistor 411d is connected in series between the data output terminal and a source connection terminal of the first thin-gate low-threshold NMOS transistor 411a and the first low-voltage calibration MOS transistor 411b. A second fixed-value resistor 411e is connected in series between a source connection terminal of the plurality of third thin-gate low-threshold NMOS transistors 411c and the data output terminal DQ.

Referring to FIG. 4, a third fixed-value resistor 421d is connected in series between the data output terminal and a source connection terminal of the second thin-gate low-threshold NMOS transistor 421a and the second low-voltage calibration MOS transistor 421b, and a fourth fixed-value resistor 421e is connected in series between a source connection terminal of the plurality of fourth thin-gate low-threshold NMOS transistors 421c and the data output terminal.

In this embodiment, a resistor is separately connected in series to the MOS transistor in the pull-up circuit 410 or the pull-down circuit 420. In this way, when settings of the ZQ calibration signal are adjusted, the precision and linearity of the MOS transistor in the pull-up circuit 410 or the pull-down circuit 420 can be maintained better.

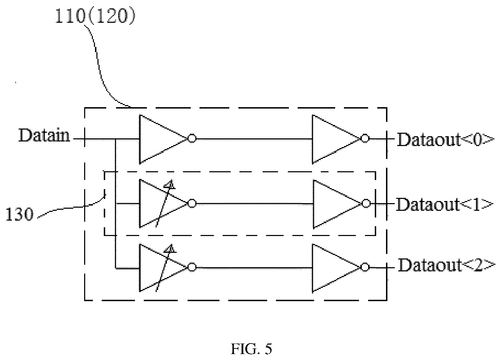

In an embodiment, referring to FIG. 5, the first-stage circuit 100 includes a first pull-up control module 110 and a first pull-down control module 120 which are identical in structure, and both the first pull-up control module 110 and the first pull-down control module 120 are configured to delay a read data signal and divide and output the data signal into data signals of a plurality of rate levels.

In a specific embodiment, referring to FIG. 5, both the first pull-up control module 110 and the first pull-down control module 120 include three delay units 130. Both the first pull-up control module 110 and the first pull-down control module 120 are configured to divide and output, by using the three delay units 130, the read serial data into data signals of three rate levels (fast, medium, and slow), that is, a fast signal Dataout<0>, a medium signal Dataout<1>, and a slow signal Dataout<2>.

In this embodiment, driver transistors of different driver strength are used as the delay units 130 to delay the signal, so as to generate data signals of different rate levels. In this way, when the data signal is transmitted to the fourth-stage circuit 400, driver transistors in the circuit are prevented from being turned on at the same time; otherwise, this may cause large noise interference on the output-stage power supply and ground terminal. In addition, a voltage conversion rate of the output-stage signal can be partly controlled by dividing the signal into signals of different rate levels.

In an embodiment, the second-stage circuit includes a second pull-up control module 220, a second pull-down control module 210, and a pull-up switch control module 230.

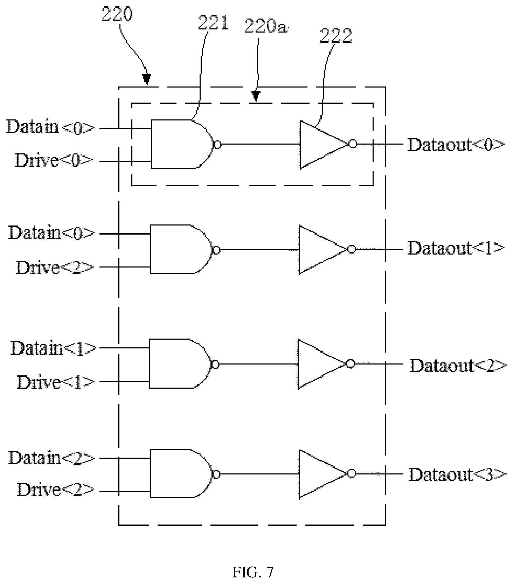

Referring to FIG. 7, the second pull-up control module 220 is configured to: receive a data signal output by the first pull-up control module 110, and according to pull-up driver setting strength, select a path to output the data signal.

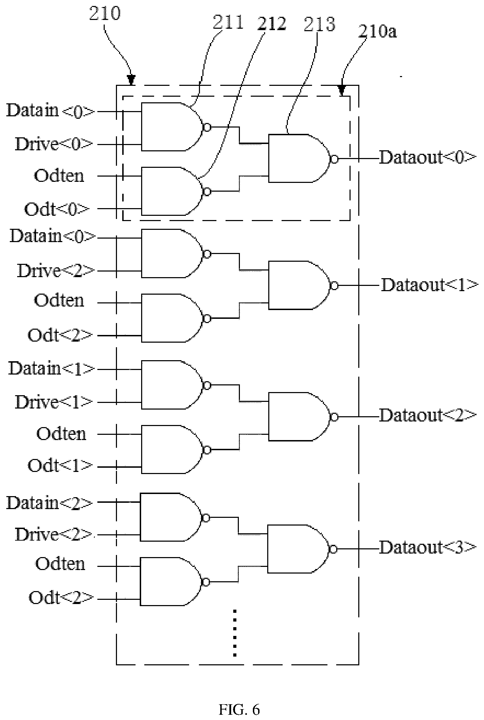

Referring to FIG. 6, the second pull-down control module 210 is configured to: receive a data signal output by the first pull-down control module 120, and according to pull-down driver setting strength and an ODT enable signal, select a path to output the data signal.

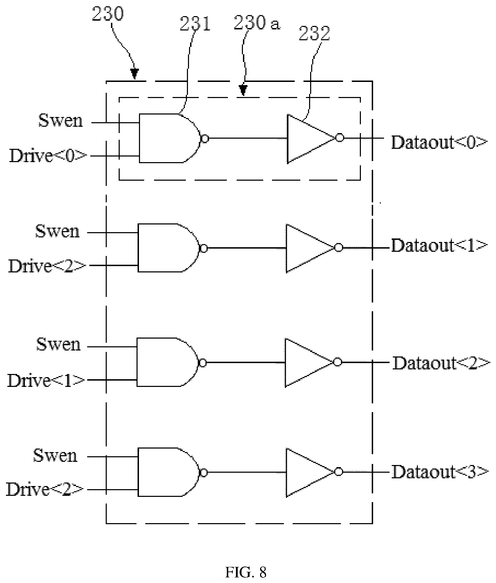

Referring to FIG. 8, the pull-up switch control module 230 is configured to receive a switch enable signal and reuse the pull-up driver setting strength, so as to control on/off of each path in the second pull-up control module 220.

In a specific embodiment, referring to FIG. 6, the second pull-down control module 210 includes four pull-down path units 210a. Each of the pull-down path units 210a includes a first NAND gate 211, a second NAND gate 212, and a third NAND gate 213. One input terminal of the first NAND gate 211 is a driver strength setting terminal, one input terminal of the second NAND gate 212 is an ODT (output high level) enable signal terminal, and the other input terminal of the second NAND gate 212 is an ODT setting terminal. Output terminals of the first NAND gate and the second NAND gate 212 are both connected to an input terminal of the third NAND gate 213, and an output terminal of the third NAND gate 213 outputs a data signal. The other input terminals of the first NAND gates 211 in two pull-down path units 210a receive a fast data signal Datain<0> output by the first pull-down control module 120, and output terminals of corresponding third NAND gates 213 output fast data signals Dataout<0> and Dataout<1>. The other input terminals of the first NAND gates 211 in the other two pull-down path units 210a receive a medium data signal Datain<1> and a slow data signal Datain<2> that are output by the first pull-down control module 120, and output terminals of corresponding third NAND gates 213 output a medium data signal Dataout<2> and a slow data signal Dataout<3>.

When the memory is in a read data mode, the ODT mode is disabled, the ODT enable signal terminal (Odten) is 0, and the output data signals (Dataout<3:0>) are controlled by driver strength setting terminals (Drive<2:0>).

When the memory is in a write data mode, the ODT mode is enabled, the ODT enable signal terminal (Odten) is 1, and the output data signals (Dataout<3:0>) are controlled by ODT setting terminals (Odt<2:0>).

Different output strengths may correspond to different combinations of fast and slow signals. If driver strength is weak, fast output may be enabled and a fast signal is used. If driver strength is strong, fast and slow signals should be combinedly used to reduce noise.

In a specific embodiment, referring to FIG. 7, the second pull-up control module 220 includes four pull-up path units 220a. Each of the pull-up path units 220a includes a fourth NAND gate 221 and a first phase inverter 222. One input terminal of the fourth NAND gate 221 is a driver strength setting terminal, an output terminal of the fourth NAND gate 221 is connected to an input terminal of the first phase inverter 222, and an output terminal of the first phase inverter 222 outputs a data signal. The other input terminals of fourth NAND gates 221 in two pull-up path units 220a receive a fast data signal Datain<0> output by the first pull-up control module 110, and output terminals of corresponding first phase inverters 222 output fast data signals Dataout<0> and Dataout<1>. The other input terminals of fourth NAND gates 221 in the other two pull-up path units 220a receive a medium data signal Datain<1> and a slow data signal Datain<2> that are output by the first pull-up control module 110, and output terminals of corresponding first phase inverters 222output a medium data signal Dataout<2> and a slow data signal Dataout<3>.

When the memory is in the read data mode, the output data signals (Dataout<3:0>) of the second pull-up control module 220 are controlled by driver strength setting terminals (Drive<2:0>). The ODT in the memory is pull-down grounded, and the pull-up control module 220 is not controlled by the ODT.

In a specific embodiment, referring to FIG. 8, the pull-up switch control module 230 includes a plurality of pull-up switch units 230a. Each of the pull-up switch units 230a includes a fifth NAND gate 231 and a second phase inverter 232. One input terminal of the fifth NAND gate 231 is a switch enable signal terminal (Swen), the other input terminal of the fifth NAND gate 231 is a pull-up driver strength setting terminal (Drive<2:0>), an output terminal of the fifth NAND gate 231 is connected to an input terminal of the second phase inverter 232, and an output terminal of the second phase inverter 232 outputs a data signal (Dataout<3:0>). The pull-up driver strength is set to reuse driver strength settings in the second pull-up control module 220, so that one pull-up switch unit 230a corresponds to one pull-up path unit 220a.

The memory reuses the driver strength setting terminal (Drive<2:0>) of the pull-up control module 220 to control the pull-up switch unit 230a, that is, one pull-up switch unit 230a controls one pull-up path unit 220a.

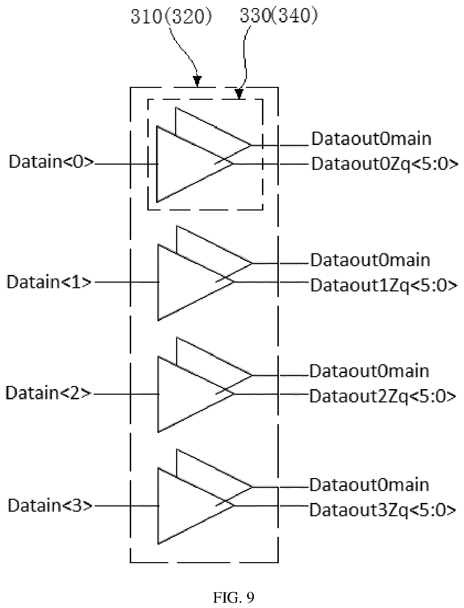

In an embodiment, referring to FIG. 9, the third-stage circuit 300 includes a third pull-up control module 310 and a third pull-down control module 320 which are identical in structure.

Referring to FIG. 9, an input terminal of the third pull-up control module 310 is connected to the second pull-up control module 220, and an output terminal of the third pull-up control module 310 is connected to the gate of the first thin-gate low-threshold NMOS transistor 411a; and the third pull-up control module 310 is configured to convert a received data signal Datain x into the pull-up voltage signal Dataout0main of the same rate and the pull-up ZQ calibration signal DataoutxZq<n:0> corresponding to the received data signal, where x≥0, and n≥1. In FIG. 9, x=0, 1, 2, 3, and n=5.

Referring to FIG. 9, an input terminal of the third pull-down control module 320 is connected to the second pull-down control module 210, and an output terminal of the third pull-down control module 320 is connected to the gate of the second thin-gate low-threshold NMOS transistor 421a; and the third pull-down control module 320 is configured to convert a received data signal Datain x into the pull-down voltage signal Dataout0main of the same rate and the pull-down ZQ calibration signal DataoutxZq<n:0> corresponding to the received data signal. In FIG. 9, x=0, 1, 2, 3, and n=5.

In a specific embodiment, referring to FIG. 9, the third pull-up control module 310 is configured to convert the two fast data signals and the medium and slow data signals Datain<3:0> received from the second pull-up control module 220 into the pull-up voltage signal Dataout0main and the pull-up ZQ calibration signalsDataout<3:0>Zq<5:0> corresponding to the received data signals (Datain and Dataout represent only the input and output statuses of the data signals).

In a specific embodiment, referring to FIG. 9, the third pull-down control module 320 is configured to convert the two fast data signals and the medium and slow data signals Datain<3:0> received from the second pull-down control module 210 into the pull-down voltage signal Dataout0main of the same rate and the pull-down ZQ calibration signalsDataout<3:0>Zq<5:0> corresponding to the data signals. Dataout<3:0>Zq<5:0> is the ZQ calibration signals Zq<5:0> input into the fourth-stage circuit 400.

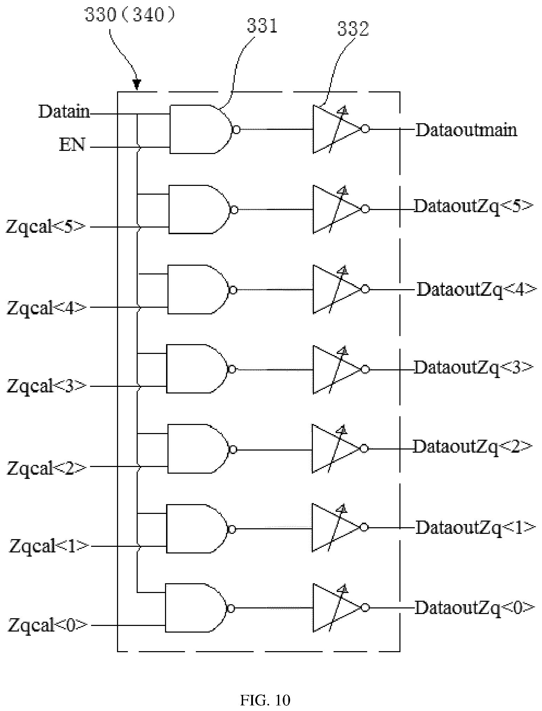

In a specific embodiment, referring to FIG. 9, the third pull-up control module 310 includes four pull-up control submodules 330. Referring to FIG. 10, the pull-up control submodule 330 includes seven sixth NAND gates 331 and seven third phase inverters 332. One input terminal of each sixth NAND gate 331 receives one piece of data information Datain output by the second pull-up control module 220, the other input terminal of the first sixth NAND gate 311 is connected to a reference signal EN, the other input terminals of the other six sixth NAND gates 331 are connected to ZQ calibration valuesZqcal<5:0>, and an output terminal of each sixth NAND gate 331 is connected to an input terminal of one third phase inverter 332. The seven third phase inverters 332 sequentially output a pull-up voltage signal Dataoutmain and pull-up ZQ calibration signals DataoutZq<5:0>.

Output terminals of the four pull-up control submodules 330, in the third pull-up control module 310, that receive the fast, medium, and slow data signals are connected to the gates of the six first thin-gate low-threshold NMOS transistors 411a in the pull-up circuit 410 according to a ratio of 1:2:2:1 or 2:1:2:1, so as to ensure that the fast data signal is connected to the gates of three first thin-gate low-threshold NMOS transistors 411a, the medium data signal is connected to the gates of two first thin-gate low-threshold NMOS transistors 411a, and the slow data signal is connected to the gate of one first thin-gate low-threshold NMOS transistor 411a.

In a specific embodiment, referring to FIG. 9, the third pull-down control module 320 includes four pull-down control submodules 340. The pull-down control submodule 340 and the pull-up control submodule 330 are identical in structure.

Referring to FIG. 10, the pull-down control submodule 340 includes seven sixth NAND gates 331 and seven third phase inverters 332. One input terminal of each sixth NAND gate 331 receives one piece of data information Datain output by the second pull-down control module 210, the other input terminal of the first sixth NAND gate 311 is connected to a reference signal EN, the other input terminals of the other six sixth NAND gates 331 are connected to ZQ calibration values Zqcal<5:0>, and an output terminal of each sixth NAND gate 331 is connected to an input terminal of one third phase inverter 332. The seven third phase inverters 332 sequentially output a pull-down voltage signal Dataoutmain and pull-down ZQ calibration signals DataoutZq<5:0>.

Output terminals of the four pull-down control submodules 340, in the third pull-down control module 320, that receive the fast, medium, and slow data signals are connected to the gates of the six second thin-gate low-threshold NMOS transistors 421a in the pull-down circuit 420 according to a ratio of 1:2:2:1 or 2:1:2:1, so as to ensure that the fast data signal is connected to the gates of three second thin-gate low-threshold NMOS transistors 421a, the medium data signal is connected to the gates of two second thin-gate low-threshold NMOS transistors 421a, and the slow data signal is connected to the gate of one second thin-gate low-threshold NMOS transistor 421a.

In this embodiment, a transmission path of a data signal is allocated and selected according to settings of a ZQ calibration value, and a voltage conversion rate of a signal output by the third-stage circuit 300 is adjusted by using the third phase inverter 332 whose voltage conversion rate is adjustable, so as to control the conversion rate of the fourth-stage circuit 400.

To achieve the foregoing objective, the present invention provides a chip, including the output circuit of the foregoing implementation.

The chip in this embodiment optimizes control of parameters under the condition of meeting the JEDEC memory standards and can be applied to two different memory data output environments.

The foregoing describes merely specific implementations of the present invention, but the protection scope of the present invention is not limited thereto. Any variation or replacement that may be readily figured out by a person skilled in the art within the technical scope disclosed in the present invention shall fall within the protection scope of the present invention. Therefore, the protection scope of the present invention shall be subject to the protection scope of the claims.

In descriptions of the present invention, it should be understood that, directions or positional relationships indicated by terms "center", "longitudinal", "transverse", "length", "width", "thickness", "above", "below", "in front of", "behind", "left", "right", "vertical", "horizontal", "top", "bottom", "inside", "outside", "clockwise", "counterclockwise", "axial", "radial", "circumferential", etc. are based on orientations or positional relationships shown in the accompanying drawings, and they are used only for describing the present invention and for description simplicity, but do not indicate or imply that an indicated apparatus or element must have a specific orientation or be constructed and operated in a specific orientation. Therefore, it cannot be understood as a limitation on the present invention.

In addition, the terms "first" and "second" are merely used for description, and shall not be understood as an indication or implication of relative importance or implicit indication of the number of indicated technical features. Therefore, a feature limited by "first" or "second" can explicitly or implicitly include one or more such features. In the description of the present invention, "a plurality of" means two or more, unless otherwise specifically limited.

In the present invention, terms "install" "link", "connect", "fix", etc. should be understood in a broad sense unless otherwise definitely stipulated or limited. For example, a connection may be a fixed connection, a detachable connection, or an integrated connection; may be a mechanical connection, an electrical connection, or a communication connection; and may be a direct connection, an indirect connection through an intermediate medium, or a connection inside two components or interaction between two components. For a person of ordinary skill in the art, specific meanings of the previous terms in the present invention can be understood based on a specific situation.

In the present invention, unless otherwise specified and limited, that a first feature is "above" or "below" a second feature may include direct contact between the first feature and the second feature, or may include indirect contact between the first feature and the second feature through other features between the first feature and the second feature. In addition, that the first feature is "above" the second feature can mean that the first feature is right above or diagonally above the second feature, or simply indicate that the first feature is at a higher position than the second feature. That the first feature is "below" the second feature can mean that the first feature is right below or diagonally below the second feature, or simply indicate that the first feature is at a lower position than the second feature.

The above disclosure provides many different embodiments or examples for implementing different structures of the present invention. To simplify the disclosure of the present invention, the components and settings of particular examples are described above. Certainly, they are merely examples and are not intended to limit the present invention. In addition, the present invention may repeat reference numbers and/or reference letters in different examples for simplicity and clarity purposes, and the repetition does not indicate a relationship between the various implementations and/or settings discussed. In addition, the present invention provides examples of various specific processes and materials, but a person of ordinary skill in the art may be aware of applications of other processes and/or uses of other materials.

## Claims

1. An output circuit, comprising:
a first-stage circuit(100), the first-stage circuit(100) being configured to read serial data in a memory and generate a plurality of first data signals with different delay parameters based on each data signal in the serial data; wherein the first-stage circuit(100) comprises a first pull-up control module(110) and a first pull-down control module(120) which are identical in structure, and both the first pull-up control module(110) and the first pull-down control module(120) are configured to delay the data signal in the serial data;
a second-stage circuit(200), connected to the first-stage circuit(100), the second-stage circuit(200) being configured to: receive drive strength settings and the plurality of first data signals output by the first-stage circuit, and generate a plurality of second data signals based at least on each of the first data signals and corresponding at least one drive strength setting, with each second data signal having a distinct transmission path; wherein the second-stage circuit comprises: a second pull-down control module(210), configured to:
generate the second data signals based at least on the first data signal output by the first pull-down control module, corresponding pull-down drive strength setting and an ODT enable signal; a second pull-up control module(220), configured to: generate the second data signals based at least on the first data signal output by the first pull-down control module and corresponding pull-up drive strength setting; and a pull-up switch control module(230), configured to receive a switch enable signal and reuse the pull-up drive strength setting, so as to control ON/OFF of each path in the second pull-up control module(220);
a third-stage circuit(300), connected to the second-stage circuit(200), the third-stage circuit(300) being configured to: receive a reference signal, a ZQ calibration value and the plurality of second data signals, and generate a plurality of ZQ calibration signals based on the ZQ calibration value and each of the second data signals, and generate a plurality of pull-up voltage signal or a plurality of pull-down voltage signal based on the reference signal and each of the second data signals, where each ZQ calibration signal, each pull-up voltage signal and each pull-down voltage signal has a same delay parameter as corresponding second data signal; wherein the third-stage circuit comprises a third pull-up control module(310) and a third pull-down control module(320) which are identical in structure;
and the third pull-up control module(310) is configured to generate a plurality of pull-up ZQ calibration signals based on the ZQ calibration value and each of the second data signals, and generate the pull-up voltage signal based on the reference voltage and each of the second data signals ; and the third pull-down control module(320) is configured to generate a plurality of pull-down ZQ calibration signals based on the ZQ calibration value and each of the second data signals, and generate the pull-down voltage signal based on the reference voltage and each of the second data signals ; and
a fourth-stage circuit(400), connected to the third-stage circuit(300), the fourth-stage circuit(400) comprises a pull-up circuit(410) and a pull-down circuit(420), wherein the pull-up circuit(410) and the pull-down circuit(420) each comprise a plurality of parallel thin-gate low-threshold NMOS transistors, and the plurality of parallel thin-gate low-threshold NMOS transistors are configured to receive the pull-up voltage signal and the pull-down voltage signal output by the third-stage circuit(300), and generate output voltage signals of the output circuit according to the ZQ calibration signal and the pull-up voltage signal and pull-down voltage signal; wherein the thin-gate low-threshold NMOS transistors are configured to eliminate the limit on a minimum operating power supply voltage caused by a MOS transistor enable threshold voltage, so that the fourth-stage circuit(400) meets a plurality of output voltage standards.

2. The output circuit according to claim 1, wherein the pull-up circuit(410) comprises a plurality of parallel pull-up branches(411), each of the pull-up branches(411) comprises a first thin-gate low-threshold NMOS transistor(411a), and all the first thin-gate low-threshold NMOS transistors(411a) are identical in structure; a drain of the first thin-gate low-threshold NMOS transistor(411a) is connected to a power supply voltage, and a gate of the first thin-gate low-threshold NMOS transistor(411a) is configured to receive the pull-up voltage signal output by the third-stage circuit(300); and sources of the first thin-gate low-threshold NMOS transistors(411a) of the pull-up branches(411) are all connected as a data output terminal.

3. The output circuit according to claim 2, wherein the pull-down circuit(420) comprises a plurality of parallel pull-down branches(421), each of the pull-down branches(421) comprises a second thin-gate low-threshold NMOS transistor(421a), and all the second thin-gate low-threshold NMOS transistors(421a) are identical in structure; a source of the second thin-gate low-threshold NMOS transistor(421a) is grounded, a drain of the second thin-gate low-threshold NMOS transistor(421a) is connected to the source of the first thin-gate low-threshold NMOS transistor(411a), and a gate of the second thin-gate low-threshold NMOS transistor(421a) is configured to receive the pull-down voltage signal output by the third-stage circuit(300).

4. The output circuit according to claim 3, wherein the third-stage circuit(300) is further configured to output the plurality of pull-up ZQ calibration signals during ZQ calibration; and each of the pull-up branches(411) comprises a plurality of third thin-gate low-threshold NMOS transistors(411c), and the third thin-gate low-threshold NMOS transistor(411c) in each pull-up branch(411) is connected in parallel to the first thin-gate low-threshold NMOS transistor(411a); and a gate of the third thin-gate low-threshold NMOS transistor(411c) is configured to receive the pull-up ZQ calibration signal, and the third thin-gate low-threshold NMOS transistor(411c) is configured to adjust an equivalent resistance of the pull-up branch(411) to RZQ according to the pull-up ZQ calibration signal.

5. The output circuit according to claim 4, wherein the third-stage circuit(300) is further configured to output the plurality of pull-down ZQ calibration signals during ZQ calibration; and
each of the pull-down branches(421) comprises a plurality of fourth thin-gate low-threshold NMOS transistors(421c), and the fourth thin-gate low-threshold NMOS transistor(421c) in each pull-down branch(421) is connected in parallel to the second thin-gate low-threshold NMOS transistor(421a); and a gate of the fourth thin-gate low-threshold NMOS transistor(421c) is configured to receive the pull-down ZQ calibration signal, and the fourth thin-gate low-threshold NMOS transistor(421c) is configured to adjust an equivalent resistance of the pull-down branch(421) to RZQ according to the pull-down ZQ calibration signal.

6. The output circuit according to claim 5, wherein the plurality of third thin-gate low-threshold NMOS transistors(411c) and the plurality of fourth thin-gate low-threshold NMOS transistors(421c) each have successively increasing equivalent width-to-length ratios.

7. The output circuit according to claim 5, wherein the pull-up circuit(410) further comprises a pull-up switch module(430), the pull-up switch module(430) comprises a number of thick-gate high-threshold NMOS transistors(431) corresponding to the number of the first thin-gate low-threshold NMOS transistors(411a), drains of the thick-gate high-threshold NMOS transistors(431) are connected to the power supply voltage, sources of the thick-gate high-threshold NMOS transistors(431) are connected to the drains of the first thin-gate low-threshold NMOS transistors(411a) in one-to-one correspondence, and gates of the thick-gate high-threshold NMOS transistors(431) are configured to receive a high-voltage threshold signal output by the third-stage circuit(300).

8. The output circuit according to claim 7, wherein each of the pull-up branches(411) further comprises at least one first low-voltage calibration MOS transistor(411b), the first low-voltage calibration MOS transistor(411b) is connected in parallel to the first thin-gate low-threshold NMOS transistor(411a), a gate of the first low-voltage calibration MOS transistor(411b) is connected to the third-stage circuit(300), and the first low-voltage calibration MOS transistor(411b) is configured to be turned on at the time of receiving a low-voltage signal.

9. The output circuit according to claim 8, wherein each of the pull-down branches(421) further comprises at least one second low-voltage calibration MOS transistor(421b), the second low-voltage calibration MOS transistor(421b) is connected in parallel to the second thin-gate low-threshold NMOS transistor(421a), a gate of the second low-voltage calibration MOS transistor(421b) is connected to the third-stage circuit(300), and the second low-voltage calibration MOS transistor(421b) is configured to be turned on at the time of receiving a low-voltage signal.

10. The output circuit according to claim 7, wherein a first fixed-value resistor(411d) is connected in series between the data output terminal and a source connection terminal of the first thin-gate low-threshold NMOS transistor(411a) and the first low-voltage calibration MOS transistor(411b), and a second fixed-value resistor(411e) is connected in series between a source connection terminal of the plurality of third thin-gate low-threshold NMOS transistors(411c) and the data output terminal; and
a third fixed-value resistor(421d) is connected in series between the data output terminal and a source connection terminal of the second thin-gate low-threshold NMOS transistor(421a) and the second low-voltage calibration MOS transistor(421b), and a fourth fixed-value resistor(421e) is connected in series between a source connection terminal of the plurality of fourth thin-gate low-threshold NMOS transistors(421c) and the data output terminal.

11. A chip comprising the output circuit according to any of claims 1 to 10.

## Patentansprüche

1. Eine Ausgangsschaltung, umfassend:
eine Schaltung der ersten Stufe (100), wobei die Schaltung der ersten Stufe (100) dazu eingerichtet ist, serielle Daten in einem Speicher zu lesen und eine Vielzahl von ersten Datensignalen mit unterschiedlichen Verzögerungsparametern basierend auf jedem Datensignal in den seriellen Daten zu erzeugen; wobei die Schaltung der ersten Stufe (100) ein erstes Pull-up-Steuermodul (110) und ein erstes Pull-down-Steuermodul (120) umfasst, die strukturell identisch sind, und sowohl das erste Pull-up-Steuermodul (110) als auch das erste Pull-down-Steuermodul (120) dazu eingerichtet sind, das Datensignal in den seriellen Daten zu verzögern;
eine Schaltung der zweiten Stufe (200), die mit der Schaltung der ersten Stufe (100) verbunden ist, wobei die Schaltung der zweiten Stufe (200) dazu eingerichtet ist: Treiberstärkeeinstellungen und die Vielzahl von ersten Datensignalen, die von der Schaltung der ersten Stufe ausgegeben werden, zu empfangen und eine Vielzahl von zweiten Datensignalen zumindest basierend auf jedem der ersten Datensignale und mindestens einer entsprechenden Treiberstärkeeinstellung zu erzeugen, wobei jedes zweite Datensignal einen unterschiedlichen Übertragungspfad aufweist; wobei die Schaltung der zweiten Stufe umfasst: ein zweites Pull-down-Steuermodul (210), das dazu eingerichtet ist:
die zweiten Datensignale zumindest basierend auf dem von dem ersten Pull-down-Steuermodul ausgegebenen ersten Datensignal, der entsprechenden Pull-down-Treiberstärkeeinstellung und einem ODT-Aktivierungssignal zu erzeugen; ein zweites Pull-up-Steuermodul (220), das dazu eingerichtet ist: die zweiten Datensignale zumindest basierend auf dem von dem ersten Pull-down-Steuermodul ausgegebenen ersten Datensignal und der entsprechenden Pull-up-Treiberstärkeeinstellung zu erzeugen; und ein Pull-up-Schaltersteuermodul (230), das dazu eingerichtet ist, ein Schalteraktivierungssignal zu empfangen und die Pull-up-Treiberstärkeeinstellung wiederzuverwenden, um dadurch das EIN/AUS jedes Pfades in dem zweiten Pull-up-Steuermodul (220) zu steuern;
eine Schaltung der dritten Stufe (300), die mit der Schaltung der zweiten Stufe (200) verbunden ist, wobei die Schaltung der dritten Stufe (300) dazu eingerichtet ist: ein Referenzsignal, einen ZQ-Kalibrierwert und die Vielzahl von zweiten Datensignalen zu empfangen und eine Vielzahl von ZQ-Kalibriersignalen basierend auf dem ZQ-Kalibrierwert und jedem der zweiten Datensignale zu erzeugen und eine Vielzahl von Pull-up-Spannungssignalen oder eine Vielzahl von Pull-down-Spannungssignalen basierend auf dem Referenzsignal und jedem der zweiten Datensignale zu erzeugen, wobei jedes ZQ-Kalibriersignal, jedes Pull-up-Spannungssignal und jedes Pull-down-Spannungssignal denselben Verzögerungsparameter wie das entsprechende zweite Datensignal aufweist; wobei die Schaltung der dritten Stufe ein drittes Pull-up-Steuermodul (310) und ein drittes Pull-down-Steuermodul (320) umfasst, die strukturell identisch sind; und das dritte Pull-up-Steuermodul (310) dazu eingerichtet ist, eine Vielzahl von Pull-up-ZQ-Kalibriersignalen basierend auf dem ZQ-Kalibrierwert und jedem der zweiten Datensignale zu erzeugen und das Pull-up-Spannungssignal basierend auf der Referenzspannung und jedem der zweiten Datensignale zu erzeugen; und das dritte Pull-down-Steuermodul (320) dazu eingerichtet ist, eine Vielzahl von Pull-down-ZQ-Kalibriersignalen basierend auf dem ZQ-Kalibrierwert und jedem der zweiten Datensignale zu erzeugen und das Pull-down-Spannungssignal basierend auf der Referenzspannung und jedem der zweiten Datensignale zu erzeugen; und
eine Schaltung der vierten Stufe (400), die mit der Schaltung der dritten Stufe (300) verbunden ist, wobei die Schaltung der vierten Stufe (400) eine Pull-up-Schaltung (410) und eine Pull-down-Schaltung (420) umfasst, wobei die Pull-up-Schaltung (410) und die Pull-down-Schaltung (420) jeweils eine Vielzahl von parallelen NMOS-Transistoren mit dünnem Gate und niedriger Schwelle umfassen und die Vielzahl von parallelen NMOS-Transistoren mit dünnem Gate und niedriger Schwelle dazu eingerichtet ist, das von der Schaltung der dritten Stufe (300) ausgegebene Pull-up-Spannungssignal und Pull-down-Spannungssignal zu empfangen und Ausgangsspannungssignale der Ausgangsschaltung gemäß dem ZQ-Kalibriersignal und dem Pull-up-Spannungssignal und dem Pull-down-Spannungssignal zu erzeugen; wobei die NMOS-Transistoren mit dünnem Gate und niedriger Schwelle dazu eingerichtet sind, die Begrenzung einer minimalen Betriebsspannungsversorgungsspannung zu beseitigen, die durch eine MOS-Transistor-Aktivierungsschwellenspannung verursacht wird, so dass die Schaltung der vierten Stufe (400) einer Vielzahl von Ausgangsspannungsstandards entspricht.

2. Die Ausgangsschaltung nach Anspruch 1, wobei die Pull-up-Schaltung (410) eine Vielzahl von parallelen Pull-up-Zweigen (411) umfasst, wobei jeder der Pull-up-Zweige (411) einen ersten NMOS-Transistor (411a) mit dünnem Gate und niedriger Schwelle umfasst und alle ersten NMOS-Transistoren (411a) mit dünnem Gate und niedriger Schwelle strukturell identisch sind; ein Drain des ersten NMOS-Transistors (411a) mit dünnem Gate und niedriger Schwelle mit einer Versorgungsspannung verbunden ist und ein Gate des ersten NMOS-Transistors (411a) mit dünnem Gate und niedriger Schwelle dazu eingerichtet ist, das von der Schaltung der dritten Stufe (300) ausgegebene Pull-up-Spannungssignal zu empfangen; und Sources der ersten NMOS-Transistoren (411a) mit dünnem Gate und niedriger Schwelle der Pull-up-Zweige (411) alle als ein Daten-Ausgangstermimal verbunden sind.

3. Die Ausgangsschaltung nach Anspruch 2, wobei die Pull-down-Schaltung (420) eine Vielzahl von parallelen Pull-down-Zweigen (421) umfasst, wobei jeder der Pull-down-Zweige (421) einen zweiten NMOS-Transistor (421a) mit dünnem Gate und niedriger Schwelle umfasst und alle zweiten NMOS-Transistoren (421a) mit dünnem Gate und niedriger Schwelle strukturell identisch sind; eine Source des zweiten NMOS-Transistors (421a) mit dünnem Gate und niedriger Schwelle geerdet ist, ein Drain des zweiten NMOS-Transistors (421a) mit dünnem Gate und niedriger Schwelle mit der Source des ersten NMOS-Transistors (411a) mit dünnem Gate und niedriger Schwelle verbunden ist und ein Gate des zweiten NMOS-Transistors (421a) mit dünnem Gate und niedriger Schwelle dazu eingerichtet ist, das von der Schaltung der dritten Stufe (300) ausgegebene Pull-down-Spannungssignal zu empfangen.

4. Die Ausgangsschaltung nach Anspruch 3, wobei die Schaltung der dritten Stufe (300) ferner dazu eingerichtet ist, die Vielzahl von Pull-up-ZQ-Kalibriersignalen während der ZQ-Kalibrierung auszugeben; und jeder der Pull-up-Zweige (411) eine Vielzahl von dritten NMOS-Transistoren (411c) mit dünnem Gate und niedriger Schwelle umfasst und der dritte NMOS-Transistor (411c) mit dünnem Gate und niedriger Schwelle in jedem Pull-up-Zweig (411) parallel zu dem ersten NMOS-Transistor (411a) mit dünnem Gate und niedriger Schwelle verbunden ist; und ein Gate des dritten NMOS-Transistors (411c) mit dünnem Gate und niedriger Schwelle dazu eingerichtet ist, das Pull-up-ZQ-Kalibriersignal zu empfangen, und der dritte NMOS-Transistor (411c) mit dünnem Gate und niedriger Schwelle dazu eingerichtet ist, einen äquivalenten Widerstand des Pull-up-Zweigs (411) gemäß dem Pull-up-ZQ-Kalibriersignal auf RZQ einzustellen.

5. Die Ausgangsschaltung nach Anspruch 4, wobei die Schaltung der dritten Stufe (300) ferner dazu eingerichtet ist, die Vielzahl von Pull-down-ZQ-Kalibriersignalen während der ZQ-Kalibrierung auszugeben;
und
jeder der Pull-down-Zweige (421) eine Vielzahl von vierten NMOS-Transistoren (421c) mit dünnem Gate und niedriger Schwelle umfasst und der vierte NMOS-Transistor (421c) mit dünnem Gate und niedriger Schwelle in jedem Pull-down-Zweig (421) parallel zu dem zweiten NMOS-Transistor (421a) mit dünnem Gate und niedriger Schwelle verbunden ist; und ein Gate des vierten NMOS-Transistors (421c) mit dünnem Gate und niedriger Schwelle dazu eingerichtet ist, das Pull-down-ZQ-Kalibriersignal zu empfangen, und der vierte NMOS-Transistor (421c) mit dünnem Gate und niedriger Schwelle dazu eingerichtet ist, einen äquivalenten Widerstand des Pull-down-Zweigs (421) gemäß dem Pull-down-ZQ-Kalibriersignal auf RZQ einzustellen.

6. Die Ausgangsschaltung nach Anspruch 5, wobei die Vielzahl von dritten NMOS-Transistoren (411c) mit dünnem Gate und niedriger Schwelle und die Vielzahl von vierten NMOS-Transistoren (421c) mit dünnem Gate und niedriger Schwelle jeweils sukzessive zunehmende äquivalente Breite-zu-Länge-Verhältnisse aufweisen.

7. Die Ausgangsschaltung nach Anspruch 5, wobei die Pull-up-Schaltung (410) ferner ein Pull-up-Schaltermodul (430) umfasst, wobei das Pull-up-Schaltermodul (430) eine Anzahl von NMOS-Transistoren (431) mit dickem Gate und hoher Schwelle umfasst, die der Anzahl der ersten NMOS-Transistoren (411a) mit dünnem Gate und niedriger Schwelle entspricht, Drains der NMOS-Transistoren (431) mit dickem Gate und hoher Schwelle mit der Versorgungsspannung verbunden sind, Sources der NMOS-Transistoren (431) mit dickem Gate und hoher Schwelle in Eins-zu-eins-Entsprechung mit den Drains der ersten NMOS-Transistoren (411a) mit dünnem Gate und niedriger Schwelle verbunden sind und Gates der NMOS-Transistoren (431) mit dickem Gate und hoher Schwelle dazu eingerichtet sind, ein von der Schaltung der dritten Stufe (300) ausgegebenes Hochspannungsschwellensignal zu empfangen.

8. Die Ausgangsschaltung nach Anspruch 7, wobei jeder der Pull-up-Zweige (411) ferner mindestens einen ersten Niederspannungskalibrierungs-MOS-Transistor (411b) umfasst, wobei der erste Niederspannungskalibrierungs-MOS-Transistor (411b) parallel zu dem ersten NMOS-Transistor (411a) mit dünnem Gate und niedriger Schwelle verbunden ist, ein Gate des ersten Niederspannungskalibrierungs-MOS-Transistors (411b) mit der Schaltung der dritten Stufe (300) verbunden ist und der erste Niederspannungskalibrierungs-MOS-Transistor(411b) dazu eingerichtet ist, zum Zeitpunkt des Empfangs eines Niederspannungssignals eingeschaltet zu werden.

9. Die Ausgangsschaltung nach Anspruch 8, wobei jeder der Pull-down-Zweige (421) ferner mindestens einen zweiten Niederspannungskalibrierungs-MOS-Transistor (421b) umfasst, wobei der zweite Niederspannungskalibrierungs-MOS-Transistor (421b) parallel zu dem zweiten NMOS-Transistor (421a) mit dünnem Gate und niedriger Schwelle verbunden ist, ein Gate des zweiten Niederspannungskalibrierungs-MOS-Transistors (421b) mit der Schaltung der dritten Stufe (300) verbunden ist und der zweite Niederspannungskalibrierungs-MOS-Transistor (421b) dazu eingerichtet ist, zum Zeitpunkt des Empfangs eines Niederspannungssignals eingeschaltet zu werden.

10. Die Ausgangsschaltung nach Anspruch 7, wobei ein erster Festwertwiderstand (411d) zwischen dem Datenausgangsanschluss und einem Source-Anschlussanschluss des ersten NMOS-Transistors (411a) mit dünnem Gate und niedriger Schwelle und des ersten Niederspannungskalibrierungs-MOS-Transistors (411b) in Reihe geschaltet ist und ein zweiter Festwertwiderstand (411e) zwischen einem Source-Anschlussanschluss der Vielzahl von dritten NMOS-Transistoren (411c) mit dünnem Gate und niedriger Schwelle und dem Datenausgangsanschluss in Reihe geschaltet ist; und
ein dritter Festwertwiderstand (421d) zwischen dem Datenausgangsanschluss und einem Source-Anschlussanschluss des zweiten NMOS-Transistors (421a) mit dünnem Gate und niedriger Schwelle und des zweiten Niederspannungskalibrierungs-MOS-Transistors (421b) in Reihe geschaltet ist und ein vierter Festwertwiderstand (421e) zwischen einem Source-Anschlussanschluss der Vielzahl von vierten NMOS-Transistoren (421c) mit dünnem Gate und niedriger Schwelle und dem Datenausgangsanschluss in Reihe geschaltet ist.

11. Ein Chip, umfassend die Ausgangsschaltung nach einem der Ansprüche 1 bis 10.

## Revendications

1. Un circuit de sortie, comprenant :
un circuit de premier étage (100), le circuit de premier étage (100) étant configuré pour lire des données série dans une mémoire et générer une pluralité de premiers signaux de données présentant différents paramètres de retard sur la base de chaque signal de données dans les données série ; dans lequel le circuit de premier étage (100) comprend un premier module de commande de pull-up (110) et un premier module de commande de pull-down (120) qui sont identiques en structure, et le premier module de commande de pull-up (110) et le premier module de commande de pull-down (120) étant tous deux configurés pour retarder le signal de données dans les données série ;
un circuit de deuxième étage (200), connecté au circuit de premier étage (100), le circuit de deuxième étage (200) étant configuré pour : recevoir des réglages de puissance de commande et la pluralité de premiers signaux de données délivrés en sortie par le circuit de premier étage, et générer une pluralité de deuxièmes signaux de données sur la base au moins de chacun des premiers signaux de données et d'au moins un réglage de puissance de commande correspondant, chaque deuxième signal de données présentant un trajet de transmission distinct ; dans lequel le circuit de deuxième étage comprend : un deuxième module de commande de pull-down (210), configuré pour :
générer les deuxièmes signaux de données sur la base au moins du premier signal de données délivré en sortie par le premier module de commande de pull-down, du réglage de puissance de commande de pull-down correspondant et d'un signal d'activation ODT ; un deuxième module de commande de pull-up (220), configuré pour : générer les deuxièmes signaux de données sur la base au moins du premier signal de données délivré en sortie par le premier module de commande de pull-down et du réglage de puissance de commande de pull-up correspondant ; et un module de commande de commutateur de pull-up (230), configuré pour recevoir un signal d'activation de commutateur et réutiliser le réglage de puissance de commande de pull-up, de manière à commander la mise en marche/l'arrêt de chaque trajet dans le deuxième module de commande de pull-up (220) ;
un circuit de troisième étage (300), connecté au circuit de deuxième étage (200), le circuit de troisième étage (300) étant configuré pour : recevoir un signal de référence, une valeur de calibrage ZQ et la pluralité de deuxièmes signaux de données, et générer une pluralité de signaux de calibrage ZQ sur la base de la valeur de calibrage ZQ et de chacun des deuxièmes signaux de données, et générer une pluralité de signaux de tension de pull-up ou une pluralité de signaux de tension de pull-down sur la base du signal de référence et de chacun des deuxièmes signaux de données, chaque signal de calibrage ZQ, chaque signal de tension de pull-up et chaque signal de tension de pull-down présentant un même paramètre de retard que le deuxième signal de données correspondant ; dans lequel le circuit de troisième étage comprend un troisième module de commande de pull-up (310) et un troisième module de commande de pull-down (320) qui sont identiques en structure ; et le troisième module de commande de pull-up (310) est configuré pour générer une pluralité de signaux de calibrage ZQ de pull-up sur la base de la valeur de calibrage ZQ et de chacun des deuxièmes signaux de données, et générer le signal de tension de pull-up sur la base de la tension de référence et de chacun des deuxièmes signaux de données ; et le troisième module de commande de pull-down (320) est configuré pour générer une pluralité de signaux de calibrage ZQ de pull-down sur la base de la valeur de calibrage ZQ et de chacun des deuxièmes signaux de données, et générer le signal de tension de pull-down sur la base de la tension de référence et de chacun des deuxièmes signaux de données ; et
un circuit de quatrième étage (400), connecté au circuit de troisième étage (300), le circuit de quatrième étage (400) comprenant un circuit de pull-up (410) et un circuit de pull-down (420), dans lequel le circuit de pull-up (410) et le circuit de pull-down (420) comprennent chacun une pluralité de transistors NMOS parallèles à grille mince et à faible seuil, et la pluralité de transistors NMOS parallèles à grille mince et à faible seuil étant configurés pour recevoir le signal de tension de pull-up et le signal de tension de pull-down délivrés en sortie par le circuit de troisième étage (300), et générer des signaux de tension de sortie du circuit de sortie selon le signal de calibrage ZQ et le signal de tension de pull-up et le signal de tension de pull-down ; dans lequel les transistors NMOS à grille mince et à faible seuil sont configurés pour éliminer la limitation sur une tension minimale d'alimentation de fonctionnement provoquée par une tension de seuil d'activation de transistor MOS, de sorte que le circuit de quatrième étage (400) satisfait à une pluralité de normes de tension de sortie.

2. Le circuit de sortie selon la revendication 1, dans lequel le circuit de pull-up (410) comprend une pluralité de branches de pull-up parallèles (411), chacune des branches de pull-up (411) comprenant un premier transistor NMOS à grille mince et à faible seuil (411a), et tous les premiers transistors NMOS à grille mince et à faible seuil (411a) étant identiques en structure ; un drain du premier transistor NMOS à grille mince et à faible seuil (411a) étant connecté à une tension d'alimentation, et une grille du premier transistor NMOS à grille mince et à faible seuil (411a) étant configurée pour recevoir le signal de tension de pull-up délivré en sortie par le circuit de troisième étage (300) ; et les sources des premiers transistors NMOS à grille mince et à faible seuil (411a) des branches de pull-up (411) étant toutes connectées en tant que borne de sortie de données.

3. Le circuit de sortie selon la revendication 2, dans lequel le circuit de pull-down (420) comprend une pluralité de branches de pull-down parallèles (421), chacune des branches de pull-down (421) comprenant un deuxième transistor NMOS à grille mince et à faible seuil (421a), et tous les deuxièmes transistors NMOS à grille mince et à faible seuil (421a) étant identiques en structure ; une source du deuxième transistor NMOS à grille mince et à faible seuil (421a) étant mise à la masse, un drain du deuxième transistor NMOS à grille mince et à faible seuil (421a) étant connecté à la source du premier transistor NMOS à grille mince et à faible seuil (411a), et une grille du deuxième transistor NMOS à grille mince et à faible seuil (421a) étant configurée pour recevoir le signal de tension de pull-down délivré en sortie par le circuit de troisième étage (300).

4. Le circuit de sortie selon la revendication 3, dans lequel le circuit de troisième étage (300) est en outre configuré pour délivrer en sortie la pluralité de signaux de calibrage ZQ de pull-up pendant le calibrage ZQ ; et chacune des branches de pull-up (411) comprend une pluralité de troisièmes transistors NMOS à grille mince et à faible seuil (411c), et le troisième transistor NMOS à grille mince et à faible seuil (411c) dans chaque branche de pull-up (411) est connecté en parallèle au premier transistor NMOS à grille mince et à faible seuil (411a) ; et une grille du troisième transistor NMOS à grille mince et à faible seuil (411c) est configurée pour recevoir le signal de calibrage ZQ de pull-up, et le troisième transistor NMOS à grille mince et à faible seuil (411c) est configuré pour ajuster une résistance équivalente de la branche de pull-up (411) à RZQ selon le signal de calibrage ZQ de pull-up.

5. Le circuit de sortie selon la revendication 4, dans lequel le circuit de troisième étage (300) est en outre configuré pour délivrer en sortie la pluralité de signaux de calibrage ZQ de pull-down pendant le calibrage ZQ ; et
chacune des branches de pull-down (421) comprend une pluralité de quatrièmes transistors NMOS à grille mince et à faible seuil (421c), et le quatrième transistor NMOS à grille mince et à faible seuil (421c) dans chaque branche de pull-down (421) est connecté en parallèle au deuxième transistor NMOS à grille mince et à faible seuil (421a) ; et une grille du quatrième transistor NMOS à grille mince et à faible seuil (421c) est configurée pour recevoir le signal de calibrage ZQ de pull-down, et le quatrième transistor NMOS à grille mince et à faible seuil (421c) est configuré pour ajuster une résistance équivalente de la branche de pull-down (421) à RZQ selon le signal de calibrage ZQ de pull-down.

6. Le circuit de sortie selon la revendication 5, dans lequel la pluralité de troisièmes transistors NMOS à grille mince et à faible seuil (411c) et la pluralité de quatrièmes transistors NMOS à grille mince et à faible seuil (421c) présentent chacun des rapports largeur/longueur équivalents augmentant successivement.

7. Le circuit de sortie selon la revendication 5, dans lequel le circuit de pull-up (410) comprend en outre un module de commutation de pull-up (430), le module de commutation de pull-up (430) comprenant un nombre de transistors NMOS à grille épaisse et à seuil élevé (431) correspondant au nombre des premiers transistors NMOS à grille mince et à faible seuil (411a), les drains des transistors NMOS à grille épaisse et à seuil élevé (431) étant connectés à la tension d'alimentation, les sources des transistors NMOS à grille épaisse et à seuil élevé (431) étant connectées aux drains des premiers transistors NMOS à grille mince et à faible seuil (411a) en correspondance biunivoque, et les grilles des transistors NMOS à grille épaisse et à seuil élevé (431) étant configurées pour recevoir un signal de seuil haute tension délivré en sortie par le circuit de troisième étage (300).

8. Le circuit de sortie selon la revendication 7, dans lequel chacune des branches de pull-up (411) comprend en outre au moins un premier transistor MOS de calibrage basse tension (411b), le premier transistor MOS de calibrage basse tension (411b) étant connecté en parallèle au premier transistor NMOS à grille mince et à faible seuil (411a), une grille du premier transistor MOS de calibrage basse tension (411b) étant connectée au circuit de troisième étage (300), et le premier transistor MOS de calibrage basse tension (411b) étant configuré pour être mis en marche au moment de recevoir un signal basse tension.

9. Le circuit de sortie selon la revendication 8, dans lequel chacune des branches de pull-down (421) comprend en outre au moins un deuxième transistor MOS de calibrage basse tension (421b), le deuxième transistor MOS de calibrage basse tension (421b) étant connecté en parallèle au deuxième transistor NMOS à grille mince et à faible seuil (421a), une grille du deuxième transistor MOS de calibrage basse tension (421b) étant connectée au circuit de troisième étage (300), et le deuxième transistor MOS de calibrage basse tension (421b) étant configuré pour être mis en marche au moment de recevoir un signal basse tension.

10. Le circuit de sortie selon la revendication 7, dans lequel une première résistance à valeur fixe (411d)est connectée en série entre la borne de sortie de données et une borne de connexion de source du premier transistor NMOS à grille mince et à faible seuil (411a) et du premier transistor MOS de calibrage basse tension (411b), et une deuxième résistance à valeur fixe (411e) est connectée en série entre une borne de connexion de source de la pluralité de troisièmes transistors NMOS à grille mince et à faible seuil (411c) et la borne de sortie de données ; et
une troisième résistance à valeur fixe (421d) est connectée en série entre la borne de sortie de données et une borne de connexion de source du deuxième transistor NMOS à grille mince et à faible seuil (421a) et du deuxième transistor MOS de calibrage basse tension (421b), et une quatrième résistance à valeur fixe (421e) est connectée en série entre une borne de connexion de source de la pluralité de quatrièmes transistors NMOS à grille mince et à faible seuil (421c) et la borne de sortie de données.

11. Une puce comprenant le circuit de sortie selon l'une quelconque des revendications 1 à 10.
